# FASCICULE DE BREVET EUROPEEN

(11) **EP 1 926 354 B1**
(45) Date de publication et mention de la délivrance du brevet: **19.05.2010**
(21) Numéro de dépôt: 07022447.2
(22) Date de dépôt: 20.11.2007
(51) Int. Cl.: H05K 1/02, H05K 3/30, H01M 2/10

(54) **Bus de conduction thermique, notamment pour unité de calcul à microprocesseur**
Wärmeleitender Bus, insbesondere für eine Rechnungseinheit mit einem Mikroprozessor.
Thermally conductive bus, in particular for a calculation unit with a microprocessor

(30) Priorité: 23.11.2006 FR 0610264
(43) Date de publication de la demande: 28.05.2008
(73) Titulaire: Continental Automotive France, 31100 Toulouse (FR)
(72) Inventeur: Gardin, Philippe, 31330 Merville (FR)
(74) Mandataire: Bonn, Roman Klemens

(56) Documents cités:
- US-A- 4 904 192
- US-A- 5 624 269
- US-B1- 6 302 709

## Description

L'invention concerne un bus de conduction thermique, notamment pour unité de calcul à microprocesseur.

De façon plus spécifique, l'invention vise un bus de conduction thermique comprenant, d'un seul tenant, une barrette thermiquement conductrice dotée d'une pluralité de languettes de connexion par brasage à des plots de connexion de composants électroniques susceptibles de s'échauffer, et un collecteur solidaire de la barrette et disposé de façon à canaliser et évacuer l'énergie thermique drainée par les languettes et transitant par la barrette.

De tels bus sont notamment utilisés dans le domaine automobile en tant que « radiateurs » pour l'évacuation de l'énergie thermique fournie par les composants électroniques de circuits imprimés.

Un des principaux obstacles rencontrés avec de tels bus réside dans le fait que, lors de l'opération de brasage, il est très difficile de trouver un compromis concernant les paramètres de cette opération de brasage (temps et température de préchauffage, temps de brasage..) garantissant une brasure correcte pour chacune des languettes.

En effet, ces paramètres sont identiques pour l'ensemble des languettes alors qu'ils devraient, de façon optimale mais non réalisable dans la pratique, être adaptés à chaque languette pour prendre en compte les différences de positionnement de ces dernières par rapport au collecteur, qui conditionnent les paramètres de la propagation de l'énergie thermique vers le dit collecteur. En effet, lorsque l'on élève la température d'une languette située à proximité du collecteur, pour la braser, il est difficile de l'amener rapidement à la température de brasage requise car la chaleur se disperse vers le collecteur et s'évacue. Ceci est d'ailleurs tout à fait normal, puisque le collecteur assure, en condition normale d'utilisation l'évacuation de la chaleur. Par contre, pendant le brasage des languettes on aimerait que le collecteur n'assure pas cette fonction d'évacuation de la chaleur de sorte que les languettes puissent rapidement atteindre leur température de brasage quelle que soit leur position par rapport au collecteur.

On connaît de la technique antérieure, des bus optimisés pour l'évacuation de l'énergie thermique US 6,302,709. Le document US 6,302,709 décrit un bus pour lequel, l'évacuation de la chaleur fournie par les composants est effectuée en remplaçant la connexion par brasage par un connecteur mécanique présentant une surface réduite de connexion, en modifiant la forme du bus et en baissant sa résistance thermique. Cependant de telles modifications ne sont pas applicables à un bus comportant des languettes de connexion par brasage. En effet ces modifications entrainent une meilleure évacuation de la chaleur aussi lors de l'opération de brasage, ce qui n'est pas souhaitable, comme expliqué précédemment. Le problème de l'invention n'est donc pas résolu.

Dans la pratique, à l'heure actuelle, il s'avère que ces difficultés ont fréquemment pour conséquences directes la mise en oeuvre de conditions de brasage (notamment temps de préchauffage) ne permettant pas de garantir un brasage correct systématique des languettes les plus proches du collecteur.

Il découle de cet état de fait qu'un nombre non négligeable de languettes s'avèrent en fait simplement « collées » sur les plots de connexion correspondants et non pas soudées avec ces derniers, avec pour conséquence des risques importants de rupture de la liaison.

L'invention vise à pallier cet inconvénient, et a pour principal objectif de fournir une solution très économique permettant d'obtenir un même gradient thermique dans toutes les languettes d'un bus de conduction thermique, et conduisant ainsi à une qualité uniforme des brasures des dites languettes quelle que soit leur position par rapport au collecteur thermique. Notamment la présente invention a pour but de permettre à des languettes connectées à un collecteur de chaleur de s'échauffer rapidement lors de leur brasage et de ne pas s'échauffer lors du fonctionnement normal du bus thermique.

A cet effet, l'invention vise un bus de conduction thermique du type décrit dans le préambule ci-dessus, comprenant, en outre, au moins en regard de chacune des languettes géométriquement les plus proches du collecteur, une lumière ménagée dans la barrette à proximité de la languette, de façon à se trouver interposée entre la dite languette et le collecteur et à former un obstacle s'opposant au cheminement direct de l'énergie thermique entre cette languette et le dit collecteur.

L'invention a donc consisté à ménager dans la barrette, en regard des languettes géométriquement les plus proches du collecteur, une simple lumière, dont la forme et les dimensions peuvent avantageusement être déterminées par des simulations, qui :
- s'oppose à la propagation de la chaleur durant un temps très court avantageusement déterminé pour correspondre au temps requis par l'opération de brasage,
- ne contrarie par contre pas la fonction de radiateur thermique du bus lors d'une utilisation classique de ce dernier, c'est à dire pour des cycles de fonctionnement de l'ordre de plusieurs minutes (supérieurs généralement à vingt minutes dans la pratique).

Cette solution, moyennant un simple usinage supplémentaire des bus actuels, sans conséquences sur le prix de revient de ces deniers, permet donc d'uniformiser les paramètres des opérations de brasage (temps et température de préchauffage, temps de brasage..) requis pour garantir une brasure correcte pour chacune des languettes.

Selon un mode de réalisation avantageux de l'invention visant un bus de conduction thermique dont chaque languette s'étend orthogonalement par rapport à un bord de la barrette, chaque lumière consiste en une fente présentant au moins un axe longitudinal orthogonal à la languette.

De plus, chacune de ces fentes est avantageusement ménagée à une distance du bord correspondant de la barrette adaptée pour délimiter, par rapport au dit bord, une bande de matière de largeur minimale calculée pour assurer la tenue mécanique de la barrette.

Par ailleurs, lorsque le bus de conduction comprend une languette ménagée dans le prolongement d'un angle de la barrette, la fente correspondante présente avantageusement la forme d'un V dont les deux branches s'étendent parallèlement aux bords de la barrette délimitant l'angle dans lequel est ménagée la languette.

D'autres caractéristiques buts et avantages de l'invention ressortiront de la description détaillée qui suit en référence au dessin annexé qui en représente à titre d'exemple non limitatif un mode de réalisation préférentiel. Sur ce dessin, la figure unique 1 est une vue en perspective d'un bus de conduction thermique selon l'invention.

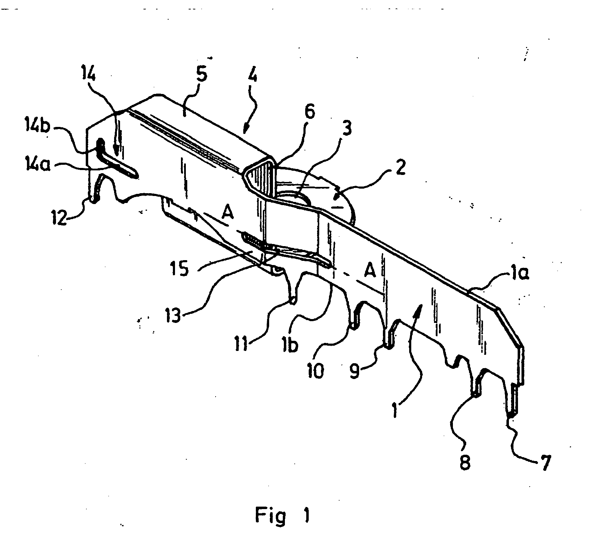

Le bus de conduction thermique selon l'invention représenté à titre d'exemple à la figure 1 est destiné à être connecté à une batterie de véhicule automobile en vue d'assurer, d'une part, l'alimentation électrique de composants électroniques, notamment d'une unité de calcul à microprocesseur, et d'autre part, l'évacuation de l'énergie thermique produite par ces composants.

De façon usuelle, ce bus comporte une barrette 1 formée d'une plaque sensiblement plane présentant une forme générale parallélépipédique délimitée notamment par deux bords longitudinaux parallèles 1 a et 1 b.

Ce bus comporte, en outre, une cosse 2 dotée d'un orifice 3 pour son montage sur une borne de batterie. Cette cosse 2, qui s'étend dans un plan orthogonal à celui de la barrette 1, est reliée à un des bords longitudinaux 1 a de cette dernière, à proximité d'une des extrémités du dit bord longitudinal, par une pièce de jonction, ou collecteur, 4 en forme de L (L inversé si l'on considère la figure 1) comportant :
- une ailette 5 de jonction avec le bord longitudinal 1 a, perpendiculaire au plan de la barrette 1,
- et une aile 6 de jonction avec la cosse 2, s'étendant parallèlement au plan de la barrette 1.

Ce bus comporte, en outre, une pluralité de languettes de connexion 7 à 12 présentant la forme générale de dents s'étendant perpendiculairement par rapport à l'autre bord longitudinal 1b de la barrette 1, deux des dites dents, notamment, étant positionnées chacune au niveau d'une des extrémités du dit bord longitudinal.

Selon l'invention, la barrette 1 est enfin percée, en regard de chacune des languettes géométriquement les plus proches du collecteur 4, en l'exemple les languettes 11 et 12 disposées de part et d'autre de ce collecteur 4, d'une lumière 13, 14 ménagée à proximité de la dite languette, de façon à se trouver interposée entre cette dernière et le collecteur 4, et à former un obstacle s'opposant au cheminement direct de l'énergie thermique entre cette languette 11, 12 et le dit collecteur.

Concernant la languette 11 ménagée en position intermédiaire le long du bord longitudinal 1 b, cette lumière 13 consiste en une fente 13 :
- s'étendant de part et d'autre de la languette 11, selon un axe longitudinal A parallèle au bord longitudinal 1b,
- ménagée à une distance du bord longitudinal 1b adaptée pour délimiter, par rapport au dit bord, une bande de matière 15 de largeur minimale calculée pour assurer la tenue mécanique de la barrette 1.

Concernant la languette 12 ménagée au niveau d'une des extrémités du bord longitudinal 1b, dans le prolongement d'un angle de la barrette 1, la fente 14 correspondante présente, quant à elle, la forme d'un L dont les deux branches 14a, 14b s'étendent parallèlement aux bords de la barrette 1 délimitant le dit angle.

Ces simples fentes 13, 14 ont pour fonction de s'opposer à la propagation de la chaleur durant un temps très court avantageusement déterminé pour correspondre au temps requis par l'opération de brasage. Par là même, elles permettent d'uniformiser les paramètres de l'opération de brasage (temps et température de préchauffage, temps de brasage..) requis pour garantir une brasure correcte pour chacune des languettes.

Il est ainsi possible de braser les languettes du bus thermique en appliquant un temps de brasage uniforme (temps pour monter la languette jusqu'à la température de brasage), quelle que soit la position de la languette par rapport au collecteur.

On notera que les lumières 13, 14 selon l'invention permettent de confiner la chaleur due à l'opération de brasage dans chaque languette au moment du brasage, sans toutefois faire obstacle à la propagation de cette chaleur vers le collecteur lorsque l'on a besoin d'utiliser le bus thermique en tant que radiateur. Ces lumières permettent donc de réaliser une double fonction (a priori contradictoire) à savoir confiner la chaleur lorsque la languette est soumise à une rapide élévation de température et dissiper cette chaleur lorsque la languette est soumise à une élévation de température de longue durée.

## Revendications

1. Bus de conduction thermique, notamment pour unité de calcul à microprocesseur, comprenant, d'un seul tenant, une barrette (1) thermiquement conductrice dotée d'une pluralité de languettes (7-12) de connexion par brasage à des plots de connexion de composants électroniques susceptibles de s'échauffer, et un collecteur (4) solidaire de la barrette (1) et disposé de façon à canaliser et évacuer l'énergie thermique drainée par les languettes (7-12) et transitant par la barrette (1), le dit bus de conduction thermique étant **caractérisé en ce qu'**il comprend, au moins en regard de chacune des languettes (11, 12) géométriquement les plus proches du collecteur (4), une lumière (13, 14) ménagée dans la barrette (1) à proximité de la languette (11, 12), de façon à se trouver interposée entre la dite languette et le collecteur (4) et à former un obstacle s'opposant au cheminement direct de l'énergie thermique entre cette languette (11, 12) et le dit collecteur.

2. Bus de conduction selon la revendication 1 dans lequel chaque languette (7-12) s'étend orthogonalement par rapport à un bord (1b) de la barrette (1), **caractérisé en ce que** chaque lumière consiste en une fente (13, 14) présentant au moins un axe longitudinal (A) orthogonal à la languette (7-12).

3. Bus de conduction selon la revendication 2 **caractérisé en ce que** chaque fente (13, 14) est ménagée à une distance du bord (1b) correspondant de la barrette (1) adaptée pour délimiter, par rapport au dit bord, une bande de matière (15) de largeur minimale calculée pour assurer la tenue mécanique de la barrette (1).

4. Bus de conduction selon l'une des revendications 1 ou 2 comprenant une languette (12) ménagée dans le prolongement d'un angle de la barrette (1), **caractérisé en ce que** la fente (14) correspondante présente la forme d'un V dont les deux branches (14a, 14b) s'étendent parallèlement aux bords de la barrette (1) délimitant l'angle dans lequel est ménagée la languette (12).

## Claims

1. Heat conduction bus, particularly for a microprocessor-based computation unit, comprising, from a single starting end, a heat-conducting strip (1) equipped with a plurality of tabs (7-12) for solder-connecting to the connection terminals of electronic components likely to become hot, and a collector (4) joined to the strip (1) and arranged so as to channel and evacuate the thermal energy drained by the tabs (7-12) and passing through the strip (1), said heat conduction bus being **characterised in that** it comprises, at least in line with each of the tabs (11, 12) geometrically the closest to the collector (4), an opening (13, 14) provided in the strip (1) near to the tab (11, 12), so as to be located interposed between said tab and the collector (4) and to form an obstacle opposing the direct routing of the thermal energy between this tab (11, 12) and said collector.

2. Conduction bus according to claim 1, in which each tab (7-12) extends orthogonally in relation to an edge (1b) of the strip (1), **characterised in that** each opening consists of a slot (13, 14) having at least a longitudinal axis (A) orthogonal to the tab (7-12).

3. Conduction bus according to claim 2, **characterised in that** each slot (13, 14) is provided at a distance from the corresponding edge (1b) of the strip (1) suitable for delimiting, in relation to said edge, a strip of material (15) of minimal width calculated to ensure the mechanical withstand strength of the strip (1).

4. Conduction bus according to one of claims 1 or 2, comprising a tab (12) provided in the extension of a corner of the strip (1), **characterised in that** the corresponding slot (14) takes the form of a V, the two branches (14a, 14b) of which extend parallel to the edges of the strip (1) delimiting the corner in which the tab (12) is provided.

## Patentansprüche

1. Wärmeleitender Bus, insbesondere für eine Rechnungseinheit mit einem Mikroprozessor, der in einem Stück eine wärmeleitende Leiste (1), die mit mehreren Zapfen (7 bis 12) zum Anlöten an die Kontaktstücke von elektronischen Bauteilen versehen ist, die sich erwärmen könnten, und einen Kollektor (4) umfasst, der fest mit der Leiste (1) verbunden und derart angeordnet ist, dass die Wärmeenergie, die von den Zapfen (7 bis 12) abgeführt wird und über die Leiste (1) fließt, kanalisiert und abgeleitet wird, wobei der wärmeleitende Bus **dadurch gekennzeichnet ist, dass** er, zumindest gegenüber jedem der Zapfen (11, 12), die dem Kollektor (4) geometrisch am nächsten sind, eine Öffnung (13, 14) umfasst, die in der Leiste (1) in der Nähe des Zapfens (11, 12) vorgesehen ist, sodass sie zwischen dem Zapfen und dem Kollektor (4) angeordnet ist und ein Hindernis für die direkte Weiterleitung der Wärmeenergie zwischen diesem Zapfen (11, 12) und dem Kollektor darstellt.

2. Leitender Bus nach Anspruch 1, bei dem jeder Zapfen (7 bis 12) senkrecht zu einem Rand (1b) der Leiste (1) verläuft, **dadurch gekennzeichnet, dass** jede Öffnung aus einem Spalt (13, 14) besteht, der mindestens eine Längsachse (A) senkrecht zum Zapfen (7 bis 12) aufweist.

3. Leitender Bus nach Anspruch 2, **dadurch gekennzeichnet, dass** jeder Spalt (13, 14) in einem geeigneten Abstand zum entsprechenden Rand (1b) der Leiste (1) vorgesehen ist, damit er relativ zu diesem Rand einen Materialstreifen (15) mit einer minimalen Breite begrenzt, die so berechnet ist, dass die mechanische Festigkeit der Leiste (1) gewährleistet ist.

4. Leitender Bus nach einem der Ansprüche 1 oder 2, der einen Zapfen (12) umfasst, der in der Verlängerung einer Ecke der Leiste (1) vorgesehen ist, **dadurch gekennzeichnet, dass** der entsprechende Spalt (14) die Form eines V aufweist, dessen beiden Schenkel (14a, 14b) parallel zu den Rändern der Leiste (1) verlaufen, die die Ecke begrenzen, in der der Zapfen (12) vorgesehen ist.
